# FASCICULE DE BREVET EUROPEEN

(11) **EP 1 130 641 B1**
(45) Date de publication et mention de la délivrance du brevet: **26.12.2007**
(21) Numéro de dépôt: 01400403.0
(22) Date de dépôt: 15.02.2001
(51) Int. Cl.: H01L 23/31, H01L 23/433, H01L 23/495, H01L 21/56

(54) **Boîtier de circuit intégré surmoulé**
Gegossene Verpackung für integrierte Schaltung
Molded integrated circuit package

(30) Priorité: 17.02.2000 FR 0001965
(43) Date de publication de la demande: 05.09.2001
(73) Titulaire: BULL S.A., 78430 Louveciennes (FR)
(72) Inventeur: Courant, Patrick, 78220 Viroflay (FR); Stricot, Yves, 78450 Villepreux (FR)
(74) Mandataire: Debay, Yves

(56) Documents cités:
- EP-A- 0 684 641
- US-A- 6 023 096
- PATENT ABSTRACTS OF JAPAN vol. 013, no. 386 (E-812), 25 août 1989 (1989-08-25) -& JP 01 135050 A (HITACHI LTD;OTHERS: 01), 26 mai 1989 (1989-05-26)
- PATENT ABSTRACTS OF JAPAN vol. 007, no. 107 (E-174), 11 mai 1983 (1983-05-11) -& JP 58 027350 A (CITIZEN TOKEI KK), 18 février 1983 (1983-02-18)

## Description

La présente invention concerne un boîtier de circuit intégré surmoulé. Elle se situe dans le domaine des boîtiers CSP, abréviation anglo-saxonne pour "Chip Scale packaging", et concerne notamment les boîtiers BGA, abréviation anglo-saxonne pour "Ball Grid Array".

Elle concerne plus particulièrement un boîtier de circuit intégré surmoulé permettant de dissiper la puissance émise par le circuit intégré au travers de la carte qui le reçoit.

Le terme "puce" sera utilisé pour définir le circuit intégré.

Le terme "ruban" sera utilisé pour définir un substrat, ordinairement sous forme de ruban, souple (flexible) sur lequel la puce est connectée par une technologie connue sous la terminologie anglo-saxonne TAB, abréviation pour "Tape Automated Bonding".

Le surmoulage des puces est largement employé par les fabricants de boîtiers de puces et notamment les boîtiers BGA.

L'opération de surmoulage est généralement utilisée pour protéger la puce vis-à-vis de son environnement extérieur tout en permettant l'évacuation des calories dissipées par la puce.

Le document EP0684641A décrit une technique mettant en oeuvre deux opérations de surmoulage successives pour éviter le phénomène connu sous la terminologie anglo-saxonne "bending" qui se produit pendant l'injection sous pression de la résine à l'intérieur du moule et qui entraîne des contraintes, voire des destructions, des connexions entre la puce et les conducteurs en cuivre supportées par le ruban.

Le procédé décrit dans ce document consiste à effectuer un premier surmoulage de la puce au plus près de la puce évitant ainsi l'effet de "bending", puis à effectuer un deuxième surmoulage englobant le premier et formant la partie supérieure du boîtier. La puce et son surmoulage sont orientés vers l'extérieur du boîtier.

Pour des puces dissipant plus de puissance, il est prévu de disposer un radiateur sur la puce. Le premier surmoulage englobe alors la puce et le radiateur sans toutefois recouvrir la partie externe du radiateur pour permettre une bonne évacuation de la chaleur vers l'extérieur du boîtier. De même le deuxième surmoulage englobe le premier sans toutefois recouvrir sa partie externe.

Cette solution s'applique à des puces qui dissipent vers l'environnement extérieur du boîtier.

Cependant, dans certaines applications, il n'est pas toujours possible d'évacuer les calories dissipées par la puce vers l'extérieur.

D'autre part cette solution de packaging ne permet pas, à partir d'une taille de boîtier déterminée, de recevoir des puces de tailles et d'épaisseurs différentes.

Le document US 6 023 096 décrit un boîtier de circuit intégré comprenant un élément semi-conducteur, des pistes conductrices sur la face d'un film conducteur, des électrodes connectées aux pistes et une couche de résine permettant de sceller les éléments du boîtier. La résine est recouverte d'une feuille métallique qui étanchéifie la résine pour éviter qu'elle ne se fissure à long terme.

Un inconvénient de ce boîtier est que la résine, lorsqu'elle est introduite, peut soulever l'élément semi-conducteur, ce qui entraîne un effet de bending.

L'invention a notamment pour but de pallier ces inconvénients.

Le boîtier selon l'invention peut ainsi répondre aux applications où il est nécessaire de dissiper par la carte sur laquelle est montée la puce, et notamment aux applications dans le domaine automobile.

L'invention a notamment pour avantage d'éviter l'effet de "bending" pendant le surmoulage et d'utiliser le même outillage de surmoulage pour une taille de boîtier déterminée et pour différentes tailles de puces admissibles pour ce boîtier.

L'invention a pour objet un boîtier surmoulé comprenant un circuit intégré (1), des pistes conductrices disposées sur une première face d'un substrat isolant souple comportant deux faces, ces pistes conductrices étant connectées à des sorties du boîtier et à une face du circuit intégré disposée en regard de la deuxième face du substrat, et un surmoulage électriquement isolant recouvrant ladite face du circuit intégré et débordant sur la deuxième face du substrat, la connexion entre les pistes conductrices et la face du circuit intégrée pouvant être réalisée selon la technologie TAB (Tape Automated Bonding), caractérisé en ce qu'il comporte, noyée dans le surmoulage, une plaque de renfort électriquement isolante, disposée à plat en regard de ladite première face du circuit intégré et débordant de part et d'autre de ladite face du circuit intégré pour recouvrir une partie du substrat et des pistes correspondantes, de manière à obstruer totalement et de manière étanche l'espace compris entre le circuit intégré et le substrat.

L'invention a aussi pour objet un procédé de surmoulage d'un boîtier comprenant un circuit intégré et des pistes conductrices portées par un substrat isolant souple et connectées à une face du circuit intégré selon la technologie TAB et à des sorties du boîtier disposées sur une face du substrat, caractérisé en ce qu'il consiste :
- à disposer l'ensemble formé par le substrat et le circuit intégré relativement à une première partie d'un moule pourvue d'une cavité contenant le circuit intégré et de bords latéraux supportant ladite face du substrat de part et d'autre du circuit intégré ;
- à disposer une plaque de renfort électriquement isolante à plat en regard de ladite face du circuit intégré et débordant de part et d'autre de ladite face du circuit intégré pour recouvrir une partie du substrat et des pistes correspondantes de manière à obstruer totalement et de manière étanche l'espace compris entre le circuit intégré et le substrat ;
- à disposer une deuxième partie du moule, pourvue de bords latéraux et d'une cuvette placée en regard de ladite cavité, sur l'ensemble formé par le substrat et le circuit intégré de façon que les bords latéraux des deux parties du moule pincent de manière étanche des parties du substrat adjacentes au circuit intégré ; et
- à injecter une résine de surmoulage dans la cuvette pour former le surmoulage du boîtier.

Il en résulte que l'invention a pour objet corollaire une carte portant au moins un boîtier incluant un circuit intégré, des pistes conductrices portées par un substrat isolant souple et connectées à une face du circuit intégré selon la technologie TAB et à des sorties du boîtier disposées sur une face du substrat, et un surmoulage électriquement isolant recouvrant ladite face du circuit intégré et débordant sur la face opposée à ladite face du substrat, caractérisé en ce que le boîtier est celui défini précédemment.

D'autres avantages et caractéristiques de la présente invention apparaîtront à la lecture de la description qui suit faite en référence aux dessins annexés dans lesquels :
- la figure 1 est une vue schématique en coupe transversale d'un exemple de structure initiale d'un boîtier équipé de billes ;
- la figure 2 est une vue schématique en coupe transversale d'un exemple d'outillage de surmoulage ;
- la figure 3 est une vue schématique en coupe transversale d'un exemple de structure d'un boîtier selon l'invention avec plaque de renfort et plaque optionnelle de refroidissement dans le cas d'une puce de grande taille ;
- la figure 4 est une vue schématique en coupe transversale de l'outillage de surmoulage selon l'invention adapté à la structure de la figure 3 ;
- la figure 5 est une vue schématique en coupe transversale d'un exemple de structure d'un boîtier selon l'invention avec plaque de renfort et plaque optionnelle de refroidissement dans le cas d'une puce de petite taille ;
- la figure 6 est une vue schématique en coupe transversale de l'outillage de surmoulage selon l'invention adapté à la structure de la figure 5 ; et
- la figure 7 est une variante d'un mode de réalisation d'un boîtier monté sur une carte ou la puce dissipe directement sur la carte.

Sur les figures, les échelles ne sont pas respectées et les mêmes éléments sont désignés par le même repère.

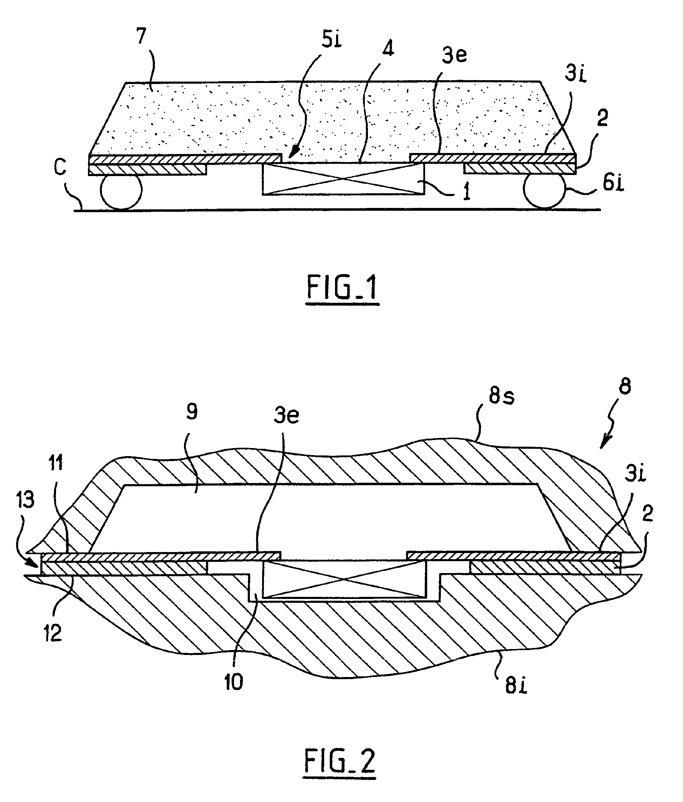

La figure 1 illustre schématiquement la structure de base d'un boîtier BGA surmoulé équipé de billes, suivant une vue en coupe transversale.

Cette structure comporte une puce 1 montée selon la technologie TAB sur un ruban isolant souple 2, par exemple en polyimide, supportant des pistes conductrices 3, ordinairement en cuivre. La face active 4 de la puce, sur laquelle sont disposés les plots de connexion 5i, correspondent à la face supérieure de la puce 1.

Par face supérieure 4, il faut comprendre la face qui est opposée à celle qui est en regard de la carte C destinée à recevoir le boîtier et pouvant évacuer les calories dissipées par la face inférieure de la puce 1. Cette disposition correspond au fait que les sorties du boîtier sont disposées sur une face du substrat qui est opposée à la face portant le surmoulage.

Le câblage de la puce 1 sur le ruban 2 est réalisé de manière connue selon la technologie "bumpless" selon laquelle les extrémités libres 3e des pistes en cuivre 3 sont connectées aux plots de connexion respectifs en aluminium 5i de la puce 1 par thermosonie. Un câblage avec "bump" est également compatible avec la structure de base du boîtier selon l'invention.

Les sorties du boîtier ainsi constitué sont destinées à être connectées sur une carte C par l'intermédiaire de billes de soudure 6i.

Dans l'exemple illustré, la partie supérieure de la structure 1, 2 et 3 est entièrement enrobée d'une résine de protection électriquement isolante 7.

Cette opération est obtenue par surmoulage. Le surmoulage du boîtier, outre la fonction de protection de la puce 1, a également pour effet de rigidifier la structure du ruban 2 et de garantir ainsi une bonne coplanarité des billes 6i lors du montage sur la carte C.

La figure 2 illustre schématiquement la forme d'un outillage utilisé pour l'opération de surmoulage et qui est rapporté sur la structure puce-ruban de la figure 1.

L'outillage de surmoulage comporte un moule 8 en deux parties : une partie supérieure 8s dont le profil intérieur 9 a une forme générale de cuvette retournée, dans le sens de la figure, et une partie inférieure 8i opposée à la première et comportant une cavité 10 disposée en regard de la cuvette 9.

Les bords latéraux 11 et 12 des deux parties respectives du moule 8s et 8i sont disposés pour pincer les parties 13 du ruban 2 qui sont adjacentes à la puce.

Le profil interne de la partie supérieure 8s du moule 8 définit la forme externe du surmoulage 7 et le profil interne de partie inférieure 8i du moule 8 définit la cavité 10 destinée à contenir la puce 1. La partie inférieure 8i du moule 8 supporte également la structure puce-ruban pendant l'opération de surmoulage.

Les bords latéraux 11 de la partie supérieure 8s s'appuient sur le ruban 2 et les pistes 3, de part et d'autre de la puce 1. La partie supérieure 8s recouvre de façon étanche la face active 4 de la puce 1 et les connexions TAB reliant les plots conducteurs 5i de la puce 1 aux extrémités 3e des pistes 3 supportées par le ruban 2.

Le surmoulage est réalisé par l'injection de la résine 7 à l'intérieur de la partie supérieure 8s du moule 8.

La partie inférieure 8i du moule 8 n'est pas destinée à recevoir de la résine 7.

Cependant, lors de l'injection de la résine 7 dans la partie supérieure 8s du moule 8, la résine 7 passe entre les extrémités 3e des pistes 3 connectées à la puce 1 et pénètre à l'intérieur de la cavité 10 de la partie inférieure 8i du moule 8 en exerçant une pression sur la puce 1, qui se soulève et reproduit à nouveau à l'effet de "bending" défini précédemment.

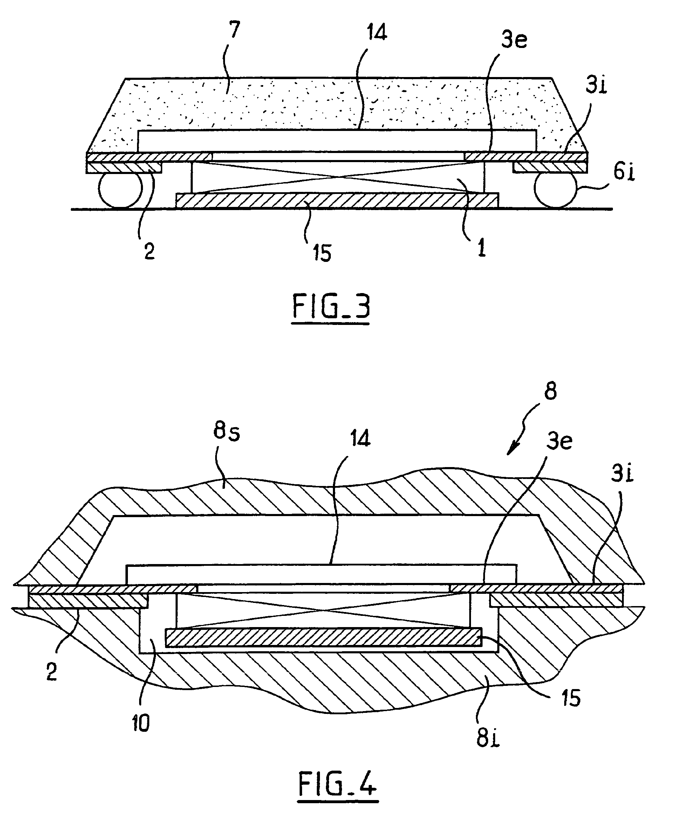

Les figures 3 à 7 illustrent des exemples de réalisation de l'invention dans lesquels une plaque de renfort 14, électriquement isolante, est disposée sur la partie supérieure du ruban 2 et les extrémités des pistes avant le surmoulage du boîtier.

Cette plaque 14 a pour avantage de renforcer la rigidité de la structure du boîtier et pour fonction d'obstruer totalement et de manière étanche l'espace compris entre la puce 1 et le ruban 2, empêchant ainsi le passage de la résine 7 à l'intérieur de la cavité 10 de la partie inférieure 8i du moule 8.

La plaque de renfort 14 est disposée à plat sur le ruban 2 et s'étend de part et d'autre de la puce 1 en débordant sur le ruban 2 de manière à recouvrir complètement et de façon étanche la face supérieure 4 de la puce 1 ainsi que les extrémités 3e des pistes 3 connectées à la puce 1.

Un procédé de surmoulage selon l'invention comporte donc les étapes suivantes consistant à :
- disposer l'ensemble formé par le ruban et la puce à l'intérieur d'une première partie d'un moule comportant une cavité contenant la puce et des bords latéraux supportant le ruban de part et d'autre de la puce ;
- disposer une plaque de renfort électriquement isolante, disposée à plat, en regard de la puce, sur la face du ruban souple opposée à la face recevant la puce et débordant de part et d'autre de la puce sur le ruban de manière à rigidifier l'ensemble formé par la puce montée sur le ruban et à obstruer totalement et de manière étanche l'espace compris entre la puce et le ruban ;
- disposer une deuxième partie du moule sur l'ensemble formé par le ruban et la puce en les recouvrant et s'appuyant sur le ruban de part et d'autre de la puce pour pincer de manière étanche le ruban entre les deux parties du moule ; et
- injecter une résine de surmoulage à l'intérieur de la deuxième partie du moule pour former le surmoulage du boîtier.

La plaque de renfort 14 peut être en epoxy d'épaisseur 250 µm. Sa taille est déterminée en fonction de la taille maximale de la puce admissible pour un boîtier déterminé.

La taille de la cavité 10 de la partie inférieure 8i du moule 8 doit être sensiblement du même ordre de grandeur que la plaque de renfort 14. Elle est également déterminée en fonction de la taille maximale de la puce admissible pour un même boîtier. Cette configuration est illustrée aux figures 3 et 4.

A titre d'exemple non limitatif, pour une taille de boîtier de 20 mm de côté destiné à contenir une puce de l'ordre de 15 mm de côté et d'épaisseur 525 µm avec 300 sorties, la taille de la plaque est de l'ordre de 17 mm de coté.

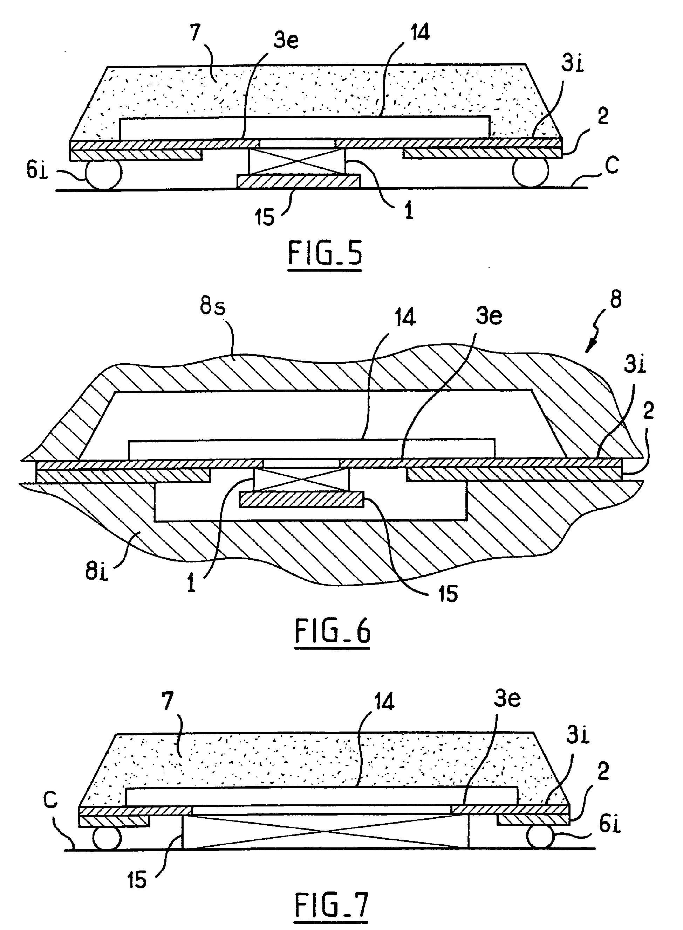

Pour les puces 1 de plus petite taille comme illustrées sur les figures 5 et 6, dont les dimensions sont par exemple de l'ordre de 8 mm de côté et de 350 µm d'épaisseur, la plaque de renfort 14 reste de taille identique à celle employée pour la puce de 15 mm de côté. De même, la partie inférieure 8i du moule 8 reste de taille identique quelle que soit la taille de la puce admissible pour le boîtier.

On comprend donc mieux les avantages apportés par une telle structure selon l'invention.

Outre le fait d'accepter différentes tailles de puce, la structure selon l'invention peut permettre le montage d'un dissipateur thermique, ou radiateur, optionnel 15 constitué par exemple d'une plaque métallique servant de dissipateur thermique, plus ou moins épaisse en fonction de la puissance dissipée par la puce et de son application.

Dans ce cas, les dimensions des billes de connexion 6i à la carte C seront adaptées pour tenir compte de l'épaisseur totale de l'empilement formé par la puce 1 et le radiateur 15.

De même, les autres dimensions du radiateur 15 seront adaptées aux dimensions de la puce 1.

Sur les figures, le radiateur 15 est représenté débordant légèrement de la puce. Le radiateur 15 est soit collé soit soudé sur la face inférieure de la puce 1.

La figure 7 illustre, à titre de variante, un mode de réalisation d'un boîtier monté sur la carte C où la puce 1 dissipe directement sur la carte C. La face inférieure de la puce peut être, par exemple, munie d'un plan conducteur, lequel peut être soudé ou collé sur une plage conductrice ménagée à la surface de la carte C en regard de la puce 1.

Dans ce cas, les dimensions des billes de connexion 6i seront adaptées pour tenir compte de l'épaisseur de la puce 1 et de la soudure ou de la colle.
1. En conclusion, l'invention a notamment les caractéristiques optionnelles suivantes. Dans le boîtier, la plaque 14 est dimensionnée en fonction de la taille maximale déterminée du circuit intégré 1 admissible pour les dimensions du boîtier. En outre, un dissipateur thermique 15 peut être disposé sur la face opposée à la face du circuit intégré 1 à sa face active et ayant une taille adaptée à la taille du circuit intégré. Pour le procédé, la taille de la cavité 10 de la première partie 8i du moule 8 est déterminée en fonction de la taille maximale du circuit intégré 1 admissible pour le boîtier. D'autre part, la plaque 14 est dimensionnée en fonction de la taille maximale du circuit intégré 1 admissible pour les dimensions du boîtier. Enfin, en ce qui concerne la carte C, la face opposée à la face active du circuit intégré est placée en regard de la carte et peut soit présenter un dissipateur thermique 15 en contact thermique avec la carte, soit dissiper directement son énergie thermique dans la carte.

## Revendications

1. Boîtier surmoulé comprenant un circuit intégré (1), des pistes conductrices (3) disposées sur une première face d'un substrat isolant souple (2) comportant deux faces, ces pistes conductrices étant connectées à des sorties du boîtier du substrat (2) situées sur sa deuxième face et à une face du circuit intégré disposée en regard de la deuxième face du substrat, et un surmoulage électriquement isolant (7) recouvrant ladite face du circuit intégré et débordant sur la deuxième face du substrat (2), la connexion entre les pistes conductrices (3) et la face du circuit intégré (1) pouvant être réalisée selon la technologie TAB (Tape Automated Bonding), **caractérisé en ce qu'**il comporte, noyée dans le surmoulage (7), une plaque de renfort (14) électriquement isolante, disposée à plat en regard de ladite première face du circuit intégré et débordant de part et d'autre de ladite face du circuit intégré pour recouvrir une partie du substrat (2) et des pistes (3) correspondantes, de manière à obstruer totalement et de manière étanche l'espace compris entre le circuit intégré (1) et le substrat (2).

2. Boîtier selon la revendication 1, **caractérisé en ce que** la plaque (14) est dimensionnée en fonction de la taille maximale déterminée du circuit intégré (1) admissible pour les dimensions du boîtier.

3. Boîtier selon la revendication 1 ou 2, **caractérisé en ce qu'**il comporte un dissipateur thermique (15) disposé sur la face opposée à ladite face du circuit intégré (1) et ayant une taille adaptée à la taille du circuit intégré.

4. Procédé de surmoulage d'un boîtier comprenant un circuit intégré (1) et des pistes conductrices (3) portées par un substrat isolant souple (2) et connectées à une face du circuit intégré selon la technologie TAB (Tape Automated Bonding) et à des sorties du boîtier disposées sur une première face du substrat (2), **caractérisé en ce qu'**il consiste :
- à disposer l'ensemble formé par le substrat (2) et le circuit intégré (1) relativement à une première partie (8i) d'un moule (8) pourvue d'une cavité (10) contenant le circuit intégré (1) et de bords latéraux (12) supportant ladite première face du substrat (2) de part et d'autre du circuit intégré (1) ;
- à disposer une plaque de renfort électriquement isolante (14) à plat en regard de ladite face du circuit intégré et débordant de part et d'autre de ladite face du circuit intégré pour recouvrir une partie du substrat (2) et des pistes (3) correspondantes de manière à obstruer totalement et de manière étanche l'espace compris entre le circuit intégré (1) et le substrat (2) ;
- à disposer une deuxième partie (8s) du moule (8), pourvue de bords latéraux (11) et d'une cuvette (9) placée en regard de ladite cavité (10), sur l'ensemble formé par le substrat (2) et le circuit intégré (1) de façon que les bords latéraux (11, 12) des deux parties du moule pincent de manière étanche des parties (13) du substrat adjacentes au circuit intégré ; et
- à injecter une résine de surmoulage dans la cuvette (9) pour former le surmoulage (7) du boîtier, la forme intérieure de la cuvette définissant la forme extérieure du surmoulage.

5. Procédé selon la revendication 4, **caractérisé en ce que** la taille de la cavité (10) de la première partie (8i) du moule (8) est déterminée en fonction de la taille maximale du circuit intégré (1) admissible pour le boîtier.

6. Procédé selon la revendication 4 ou 5, **caractérisé en ce que** la plaque (14) est dimensionnée en fonction de la taille maximale déterminée du circuit intégré (1) admissible pour les dimensions du boîtier.

7. Carte (C) portant au moins un boîtier incluant un circuit intégré (1), des pistes conductrices (3) portées par un substrat isolant souple (2) et connectées à une face du circuit intégré selon la technologie TAB et à des sorties du boîtier disposées sur une face du substrat (2), et un surmoulage électriquement isolant (7) recouvrant ladite face du circuit intégré et débordant sur la face opposée à ladite face du substrat, **caractérisé en ce que** le boîtier est défini par l'une des revendications 1 à 3.

8. Carte selon la revendication 7, **caractérisé en ce que** la face opposée à ladite face du circuit intégré est placée en regard de la carte et présente un dissipateur thermique (15) en contact thermique avec la carte.

9. Carte selon la revendication 7, **caractérisé en ce que** la face opposée à ladite face du circuit intégré est placée en regard de la carte et dissipe directement son énergie thermique dans la carte.

## Claims

1. Moulded casing comprising an integrated circuit (1), conductive tracks (3) disposed on a first face of a flexible insulating substrate comprising two faces, these conductive tracks being connected to outputs from the casing of the substrate (2) located on its second face and to one face of the integrated circuit disposed facing the second face of the substrate, and an electrically insulating moulding (7) covering said face of the integrated circuit and overlapping the second face of the substrate (2), the connection between the conductive tracks (3) and the face of the integrated circuit (1) being able to be achieved by TAB (Tape Automated Bonding) technology, **characterised in that** it comprises, embedded in the mould (7), an electrically insulating reinforcement plate (14), disposed flat facing said first face of the integrated circuit and overlapping either side of said face of the integrated circuit in order to cover part of the substrate (2) and the corresponding tracks (3), so as to obstruct completely and seal the space between the integrated circuit (1) and the substrate (2).

2. Casing according to Claim 1, **characterised in that** the plate (14) is dimensioned as a function of the given maximum size of the integrated circuit (1) acceptable for the dimensions of the casing.

3. Casing according to Claim 1 or 2, **characterised in that** it comprises a heat sink (15) disposed on the face opposite said face of the integrated circuit (1) and having a size adapted to the size of the integrated circuit.

4. Method of moulding a casing comprising an integrated circuit (1) and conductive tracks (3) carried by a flexible insulating substrate (2) and connected to one face of the integrated circuit by TAB (Tape Automated Bonding) technology and to outputs from the casing disposed on a first face of the substrate (2), **characterised in that** it consists:
- in disposing the assembly formed by the substrate (2) and the integrated circuit (1) relative to a first portion (8i) of a mould (8) provided with a cavity (10) containing the integrated circuit (1) and with side edges (12) supporting said first face of the substrate (2) on either side of the integrated circuit (1);
- in disposing an electrically insulating reinforcement plate (14) flat, facing said face of the integrated circuit and overlapping either side of said face of the integrated circuit in order to cover part of the substrate (2) and the corresponding tracks (3) so as to block completely and seal the space between the integrated circuit (1) and the substrate (2);
- in disposing a second portion (8s) of the mould (8), provided with side edges (11) and a cup (9) placed facing said cavity (10), on the assembly formed by the substrate (2) and the integrated circuit (1) so that the side edges (11, 12) of the two portions of the mould grip and seal the portions (13) of the substrate adjacent to the integrated circuit; and
- in injecting a moulding resin into the cup (9) in order to form the moulding (7) for the casing, the internal shape of the cup defining the outer shape of the moulding.

5. Method according to Claim 4, **characterised in that** the size of the cavity (10) of the first portion (8i) of the mould (8) is determined as a function of the maximum size of the integrated circuit (1) acceptable for the casing.

6. Method according to Claim 4 or 5, **characterised in that** the plate (14) is dimensioned as a function of the maximum size of the integrated circuit (1) acceptable for the dimensions of the casing.

7. Card (C) carrying at least one casing including an integrated circuit (1), conductive tracks (3) carried by a flexible insulating substrate (2) and connected to one face of the integrated circuit by TAB (Tape Automated Bonding) technology and to outputs from the casing positioned on one face of the substrate (2), and an electrically insulating moulding (7) covering said face of the integrated circuit and overlapping the face opposite said face of the substrate, **characterised in that** the casing is defined by one of Claims 1 to 3.

8. Card according to Claim 7, **characterised in that** the face opposite said face of the integrated circuit is placed facing the card and has a heat sink (15) in thermal contact with the card.

9. Card according to Claim 7, **characterised in that** the face opposite said face of the integrated circuit is placed facing the card and dissipates its thermal energy directly into the card.

## Patentansprüche

1. Aufgeformtes Gehäuse umfassend eine integrierte Schaltung (1), Leiterbahnen (3), die auf einer ersten Oberfläche eines zwei Oberflächen umfassenden, biegsamen, isolierenden Substrats (2) angeordnet sind, wobei die Leiterbahnen verbunden sind mit Ausgängen des Gehäuses des Substrats (2), die sich auf seiner zweiten Oberfläche befinden, und mit einer Oberfläche der integrierten Schaltung, die der zweiten Substratoberfläche gegenüberliegend angeordnet ist, und ferner umfassend eine elektrisch isolierende Überformung (7), die die genannte Oberfläche der integrierten Schaltung überdeckt und auf die zweite Oberfläche des Substrats (2) überragt, wobei die Verbindung zwischen den Leiterbahnen (3) und der Oberfläche der integrierten Schaltung (1) gemäß der TAB-Technologie (Tape Automated Bonding) realisiert sein kann, **dadurch gekennzeichnet, daß** es ferner eine elektrisch isolierende Verstärkungsplatte (14) umfaßt, die in der Überformung (7) eingeschlossen und flach gegenüber der genannten ersten Oberfläche der integrierten Schaltung angeordnet ist und die auf beiden Seiten der genannten Oberfläche der integrierten Schaltung übersteht, um einen Teil des Substrats (2) und der entsprechenden Bahnen (3) zu überdecken, dergestalt, daß der Raum zwischen der integrierten Schaltung (1) und dem Substrat (2) vollständig und abdichtend blockiert ist.

2. Gehäuse gemäß Anspruch 1, **dadurch gekennzeichnet, daß** die Platte (14) abhängig von der vorbestimmten maximalen Größe der integrierten Schaltung (1), die für die Abmessungen des Gehäuses zulässig ist, dimensioniert ist.

3. Gehäuse gemäß Anspruch 1 oder 2, **dadurch gekennzeichnet, daß** es einen Kühlkörper (15) umfaßt, der auf der der genannten Oberfläche der integrierten Schaltung (1) gegenüberliegenden Oberfläche angeordnet ist und eine Größe hat, die der Größe der integrierten Schaltung angepaßt ist.

4. Verfahren zum Aufformen eines Gehäuses, das eine integrierte Schaltung (1) und Leiterbahnen (3) umfaßt, die von einem biegsamen, isolierenden Substrat (2) getragen sind und verbunden sind mit einer Oberfläche der integrierten Schaltung gemäß der TAB-Technologie (Tape Automated Bonding) und mit Ausgängen des Gehäuses, die auf einer ersten Oberfläche des Substrats (2) angeordnet sind, **dadurch gekennzeichnet, daß** es aus folgenden Schritten besteht:
- Anordnen der aus dem Substrat (2) und der integrierten Schaltung (1) gebildeten Einheit relativ zu einem ersten Teil (8i) einer Form (8), das ausgestattet ist mit einer Kavität (10), die die integrierte Schaltung (1) enthält, und mit Seitenrändern (12), die die genannte erste Oberfläche des Substrats (2) auf beiden Seiten der integrierten Schaltung (1) tragen;
- Anordnen einer elektrisch isolierenden Verstärkungsplatte (14) flach gegenüber der genannten Oberfläche der integrierten Schaltung und auf beiden Seiten der genannten Oberfläche der integrierten Schaltung überragend, um einen Teil des Substrats (2) und der entsprechenden Bahnen (3) zu bedecken, dergestalt, daß der Raum zwischen der integrierten Schaltung (1) und dem Substrat (2) vollständig und abdichtend blockiert wird;
- Anordnen eines zweiten Teils (8s) der Form (8), das ausgestattet ist mit Seitenrändern (11) und einer Wanne (9), die gegenüber der genannten Kavität (10) plaziert ist, auf der aus dem Substrat (2) und der integrierten Schaltung (1) gebildeten Einheit, dergestalt, daß die Seitenränder (11, 12) der zwei Teile der Form Teile (13) des Substrates, die an die integrierte Schaltung angrenzen, abdichtend einklemmen; und
- Einspritzen eines Überformharzes in die Wanne (9), um die Überformung (7) für das Gehäuse zu bilden, wobei die innere Form der Wanne die äußere Form der Überformung bestimmt.

5. Verfahren gemäß Anspruch 4, **dadurch gekennzeichnet, daß** die Größe der Kavität (10) des ersten Teils (8i) der Form (8) bestimmt wird abhängig von der maximalen Größe der für das Gehäuse zulässigen integrierten Schaltung (1).

6. Verfahren nach Anspruch 4 oder 5, **dadurch gekennzeichnet, daß** die Platte (14) abhängig von der vorbestimmten maximalen Größe der integrierten Schaltung (1), die für die Abmessungen des Gehäuses zulässig ist, dimensioniert wird.

7. Karte (C), die wenigstens ein Gehäuse trägt, das eine integrierte Schaltung (1), Leiterbahnen (3), die von einem biegsamen, isolierenden Substrat (2) getragen sind und verbunden sind mit einer Oberfläche der integrierten Schaltung gemäß der TAB-Technologie und mit Ausgängen des Gehäuses, die auf einer Oberfläche des Substrats (2) angeordnet sind, und eine elektrisch isolierende Überformung (7) enthält, die die genannte Oberfläche der integrierten Schaltung bedeckt und auf die der genannten Substratoberfläche gegenüberliegenden Oberfläche überragt, **dadurch gekennzeichnet, daß** das Gehäuse durch einen der Ansprüche 1 bis 3 definiert ist.

8. Karte gemäß Anspruch 7, **dadurch gekennzeichnet, daß** die Oberfläche, die der genannten Oberfläche der integrierten Schaltung gegenüberliegt, gegenüber der Karte plaziert ist und einen Kühlkörper (15) aufweist, der in einem thermischen Kontakt mit der Karte steht.

9. Karte gemäß Anspruch 7, **dadurch gekennzeichnet, daß** die Oberfläche, die der genannten Oberfläche der integrierten Schaltung gegenüberliegt, gegenüber der Karte plaziert ist und seine thermische Energie direkt in die Karte ableitet.
